# FASCICULE DE BREVET EUROPEEN

(11) **EP 3 273 483 B1**
(45) Date de publication et mention de la délivrance du brevet: **26.04.2023**
(21) Numéro de dépôt: 17156146.7
(22) Date de dépôt: 14.02.2017
(51) Int. Cl.: H01L 21/8228, H01L 21/8249, H01L 21/331, H01L 27/082, H01L 29/732, H01L 29/06, H01L 29/423, H01L 29/08, H01L 27/07, H01L 27/06

(54) **PROCÉDÉ DE FABRICATION D'UN TRANSISTOR BIPOLAIRE DE TYPE PNP EN PARALLÈLE DE LA FABRICATION D'UN TRANSISTOR BIPOLAIRE DE TYPE NPN ET DE TRANSISTORS MOS À CANAL N ET À CANAL P**
HERSTELLUNGSVERFAHREN EINES BIPOLAREN TRANSISTORS VOM TYP PNP, PARALLEL ZU EINEM BIPOLAREN TRANSISTOR VOM TYP NPN, SOWIE MOS TRANSISTOREN MIT EINEM N- UND EINEM P-KANAL
METHOD FOR MANUFACTURING A PNP BIPOLAR TRANSISTOR PARALLEL TO AN NPN BIPOLAR TRANSISTOR, AS WELL AS N- AND P-CHANNEL MOS TRANSISTORS

(30) Priorité: 22.07.2016 FR 1657067
(43) Date de publication de la demande: 24.01.2018
(73) Titulaire: STMicroelectronics (Crolles 2) SAS, 38920 Crolles (FR)
(72) Inventeur: CHEVALIER, Pascal, 38530 CHAPAREILLAN (FR); AVENIER, Grégory, 38000 GRENOBLE (FR)
(74) Mandataire: Cabinet Beaumont

(56) Documents cités:
- EP-A1- 0 849 792
- WO-A1-2008/068340
- US-A1- 2005 029 624
- US-A1- 2005 077 571
- US-B2- 6 767 797

## Description

### Domaine

La présente demande concerne un procédé de fabrication de transistors bipolaires de type PNP et plus particulièrement un procédé de fabrication de transistors bipolaires de type PNP compatibles avec la fabrication en parallèle de transistors bipolaires de type NPN, de transistors MOS à canal N et de transistors MOS à canal P, dans une technologie dite BiCMOS.

### Exposé de l'art antérieur

On connaît divers procédés de fabrication de transistors bipolaires de divers types et de transistors MOS de divers types. Ces procédés sont généralement prévus pour réduire le nombre d'étapes de fabrication et pour optimiser chacun des transistors.

On propose ici un procédé minimisant le nombre d'étapes et optimisant les performances de transistors bipolaires de type PNP et de type NPN. Les performances du transistor bipolaire de type PNP recherchées sont par exemple un gain supérieur à 100 et une fréquence de transition supérieure à 25 GHz. Les performances du transistor bipolaire de type NPN recherchées sont par exemple une fréquence de coupure supérieure à 300 GHz.

Le document WO 2008/068340 concerne un procédé de fabrication dans-un substrat P d'un transistor bipolaire PNP en parallèle avec un transistor bipolaire NPN. La base est déposée après la formation des régions d'isolation dopées et les régions du collecteur, et est formée dans la fenêtre d'émetteur.

Le document US 6 767 797 concerne un procédé de fabrication de transistors bipolaires complémentaires alignés.

Le document US 2005/029624 concerne un circuit intégré ayant des transistors bipolaires PNP et NPN et le procédé de fabrication associé.

Le document US 2005/077571 concerne un dispositif de circuit intégré semiconducteur.

Le document EP 0 849 792 concerne un transistor bipolaire et sa capacité.

### Résumé

Ainsi, l'invention concerne un procédé de fabrication d'un transistor bipolaire de type PNP en parallèle de la fabrication d'un transistor bipolaire de type NPN, et de transistors MOS à canal N et à canal P, selon la rèvendication 1.

Selon un mode de réalisation, à l'étape e), l'implantation du troisième caisson est réalisée par une implantation profonde d'un quatrième caisson dopé de type P et par une implantation d'un cinquième caisson dopé de type P.

Selon un mode de réalisation, la deuxième couche est en outre dopée par des atomes de carbone.

Selon un mode de réalisation, le procédé comprend en outre une étape j), postérieure à l'étape i), de formation de siliciurations sur les faces supérieures des première, deuxième et troisième régions et de la deuxième couche.

Selon un mode de réalisation, le procédé comprend en outre une étape k) postérieure à l'étape i), de formation d'espaceurs sur les bords latéraux de la deuxième couche.

Selon un mode de réalisation, à l'étape g), les première et deuxième couches isolantes sont retirées par gravure humide.

Selon un mode de réalisation, à l'étape a), la première couche semiconductrice est déposée par épitaxie.

Selon un mode de réalisation, la première couche isolante est une couche d'oxyde de silicium et la deuxième couche isolante est une couche de nitrure.

Selon un mode de réalisation, le matériau isolant est de l'oxyde de silicium.

Selon un mode de réalisation, le substrat est en silicium.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

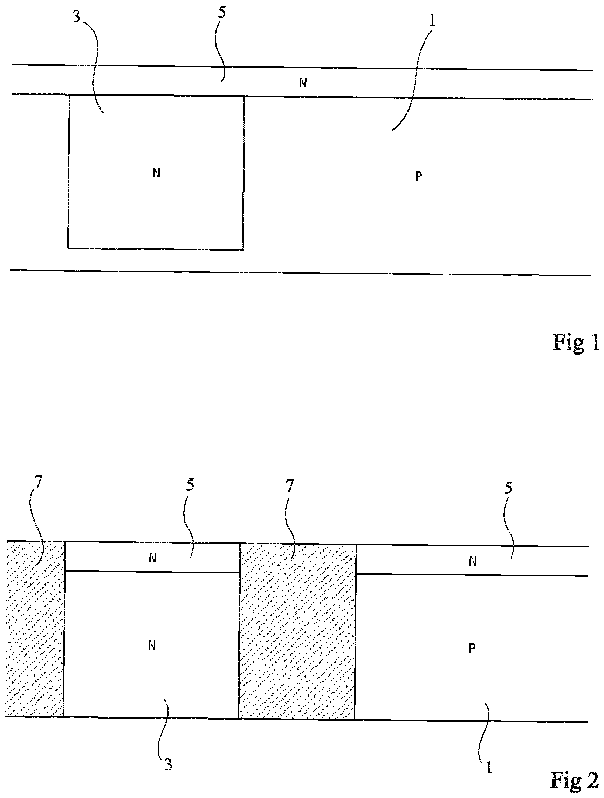

les figures 1 à 21 sont des vues en coupe illustrant les étapes successives d'un mode de réalisation d'un procédé de fabrication d'un transistor bipolaire de type PNP et d'un transistor bipolaire de type NPN.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés.

Dans la description qui suit, lorsque l'on fait référence à des qualificatifs de position absolue, tels que les termes "gauche", "droite", etc., ou relative, tel que les termes "dessus", "inférieur" et "supérieur" il est fait référence à l'orientation des figures. Sauf précision contraire, les expressions "de l'ordre de" et "sensiblement" signifient à 10 % près, de préférence à 5 % près.

Les figures 1 à 21 sont des vues en coupe illustrant des étapes successives d'un procédé de fabrication d'un transistor bipolaire de type PNP et d'un transistor bipolaire de type NPN. Ce procédé permet en outre la réalisation simultanée de transistors MOS à canal N et de transistors MOS à canal P, mais les étapes de réalisation des transistors MOS ne sont pas détaillées ici.

On a représenté, dans la partie droite de chacune des figures 1 à 21, des étapes de fabrication d'un transistor bipolaire de type PNP, et dans la partie gauche de chacune des figures 1 à 21, des étapes de fabrication d'un transistor bipolaire de type NPN.

La figure 1 illustre une étape du procédé de fabrication de transistors bipolaires de type PNP et de type NPN. La structure de départ est une couche semiconductrice 1, couramment en silicium, dopée de type P. La couche 1, appelée ci-après substrat, est formée sur un support semiconducteur. Ce support semiconducteur est par exemple faiblement dopé de type N. Par exemple, la couche 1 est formée par épitaxie. Un caisson semiconducteur 3 dopé de type N est formé dans le substrat 1 à l'emplacement où on souhaite former le transistor de type NPN. Le caisson 3 est formé à partir de la face supérieure du substrat 1. Une couche semiconductrice 5 dopée de type N, qui servira de base dans le transistor PNP, est déposée par épitaxie sur la face supérieure du substrat 1 et sur la face supérieure du caisson 3. A titre d'exemple, la couche 5 a une épaisseur comprise entre 200 et 600 nm, par exemple de l'ordre de 400 nm.

A l'étape de la figure 2, des tranchées isolantes 7 profondes (en anglais "Deep Trench Isolation", DTI) sont réalisées sur toute l'épaisseur de la couche 1, comprise par exemple entre 2 et 6 µm, typiquement de l'ordre de 4 µm. Les tranchées 7 entourent la zone de fabrication du transistor PNP et la zone de fabrication du transistor NPN bien que la tranchée ne soit pas représentée sur la droite des figures 1 à 21.

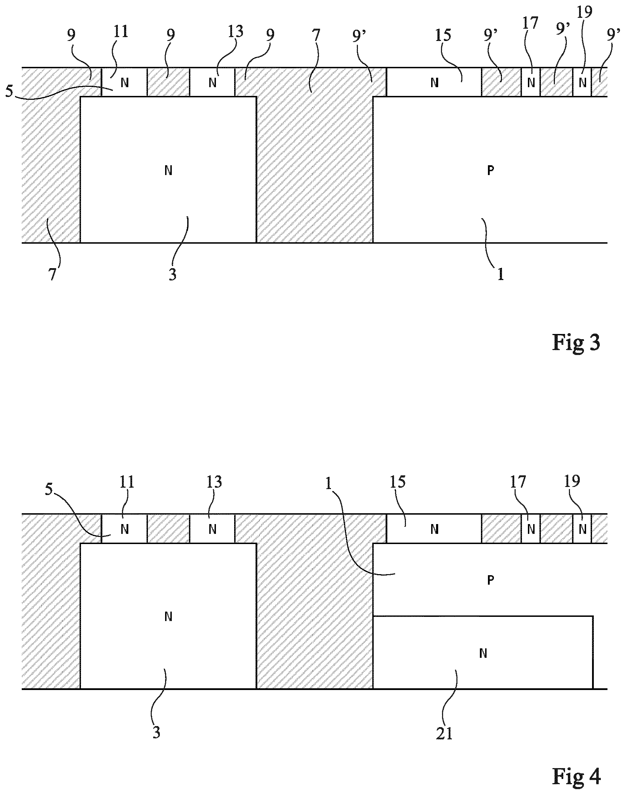

A l'étape de la figure 3, la portion de la couche 5 reposant sur le caisson 3 est divisée par des tranchées isolantes peu profondes 9 (en anglais "Shallow Trench Isolation", STI) en au moins une région 11 et une région 13. Les régions 11 et 13 sont de largeur sensiblement identique. La portion de la couche 5 reposant sur le substrat 1 est divisée par des tranchées 9' en trois régions 15, 17 et 19. La région 15 est plus large que les régions 17 et 19, qui sont sensiblement de même largeur.

A l'étape de la figure 4, un caisson 21 dopé de type N est formé par implantation profondément dans le substrat 1 de la zone de fabrication du transistor de type PNP. Le caisson 21 est formé du côté de la face inférieure du substrat 1 et s'étend sous toute la largeur de la zone de fabrication du transistor bipolaire de type PNP.

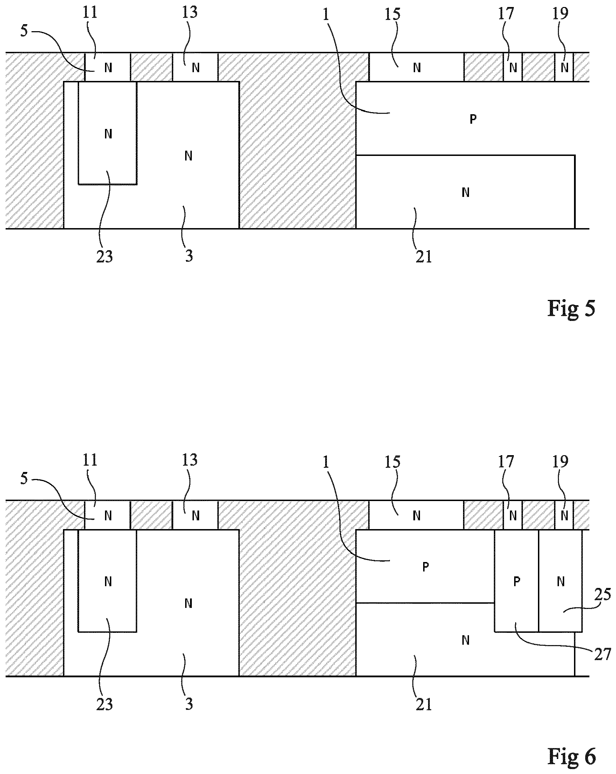

A l'étape de la figure 5, un caisson 23 fortement dopé de type N est formé par implantation dans le caisson 3 de la zone de fabrication du transistor bipolaire de type NPN. Le caisson 23 est formé sous et en contact avec la face supérieure du caisson 3 et s'étend dans la direction de la partie inférieure du caisson 3. Le caisson 23 est positionné sous la région 11 de la couche 5.

A l'étape de la figure 6, un caisson 25 dopé de type N et un caisson semiconducteur 27 dopé de type P sont formés par implantation dans le substrat 1 de la zone de fabrication du transistor bipolaire de type PNP. Les caissons 25 et 27 sont adjacents, et s'étendent à partir de la face supérieure du substrat 1 jusqu'au caisson 21. Le caisson 25 dopé de type N s'étend sous la région 19 de la couche 5. Le caisson 27 dopé de type P s'étend sous la région 17 de la couche 5. Bien entendu pour économiser des étapes de fabrication, le caisson de type N 25 peut être formé en même temps que le caisson de type N 23.

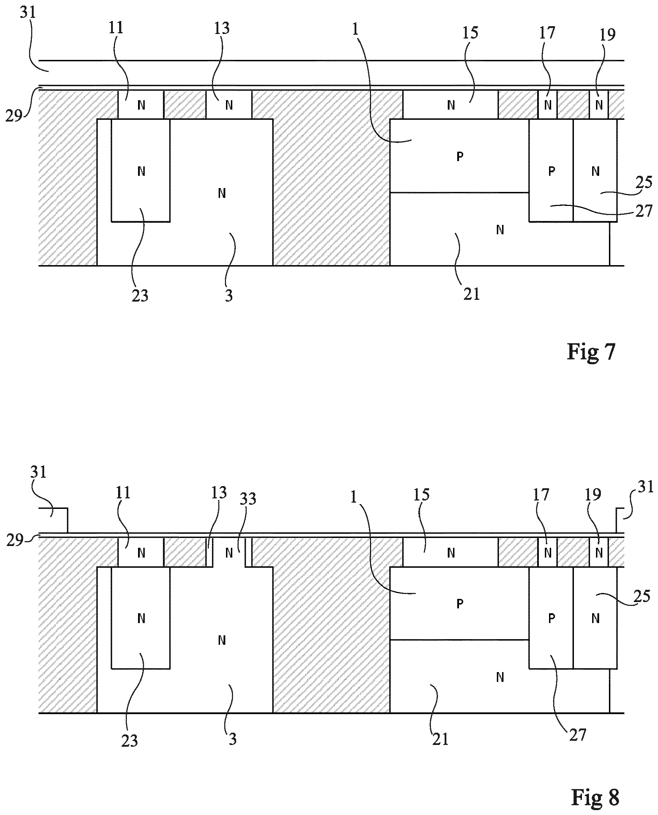

A l'étape de la figure 7, une couche isolante 29 et une couche de silicium polycristallin 31 sont déposées successivement sur la face supérieure de la structure. Les couches 29 et 31 servent par ailleurs à la réalisation de la grille isolée des transistors MOS fabriqués en parallèle des transistors bipolaires. A titre d'exemple, la couche isolante 29 est en oxyde ou en oxynitrure de silicium.

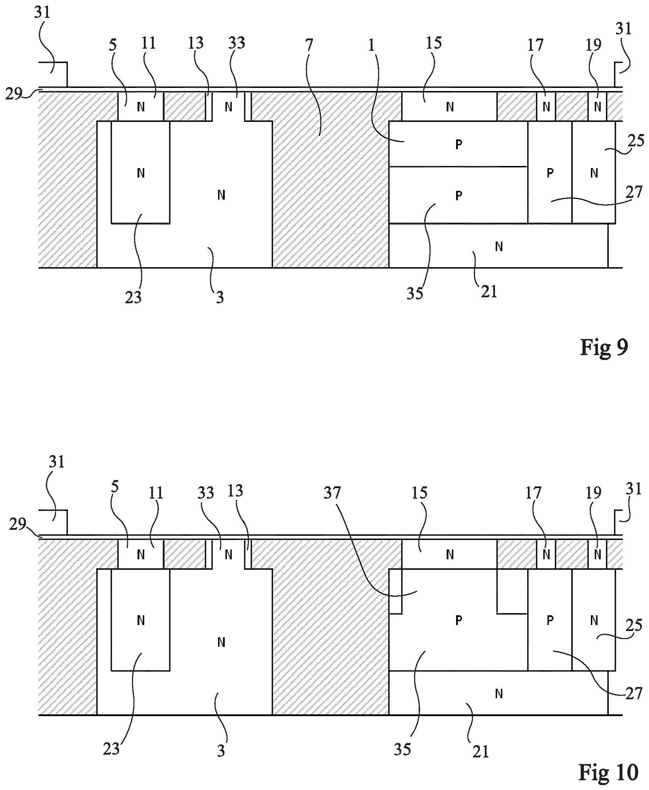

A l'étape de la figure 8, la couche de silicium polycristallin 31 est retirée par masquage de la structure au-dessus des zones de fabrication des transistors bipolaires de type NPN et de type PNP. Les étapes de fabrication représentées par les figures 9 à 19 sont spécifiques à la fabrication de transistors bipolaires. Du côté gauche de la figure, un caisson 33 semiconducteur spécifiquement dopé de type N est formé dans la partie centrale de la région 13 de la couche 5. Le caisson 33 est destiné à former la zone de sous-collecteur du transistor bipolaire de type NPN (en anglais "Selectively Implanted Collecter", SIC). Le caisson 33 s'étend sur toute l'épaisseur de la région 13 de la couche 5.

A l'étape de la figure 9, du côté droit de la figure, un caisson semiconducteur 35 dopé de type P est formé par implantation profonde dans le substrat 1. Le caisson 35 est formé sur la face supérieure du caisson 21 et s'étend latéralement entre la tranchée 7 et le caisson 27. Le caisson 35 est positionné sous la région 15 de la couche 5 mais n'est pas en contact avec celle-ci. Le caisson 35 forme le collecteur extrinsèque du transistor bipolaire de type PNP.

A l'étape de la figure 10, un caisson 37 dopé de type P est formé par implantation dans le substrat 1 de la zone de fabrication du transistor bipolaire de type PNP. Le caisson 37 est formé entre la face supérieure du caisson 35 et la face inférieure de la région 15 de la couche 5. Le caisson 37 n'est pas en contact latéral avec le caisson 27. Le caisson 37 forme le collecteur intrinsèque du transistor bipolaire de type PNP. Le collecteur complet a une épaisseur comprise entre 800 et 1200 nm, par exemple de l'ordre de 950 nm.

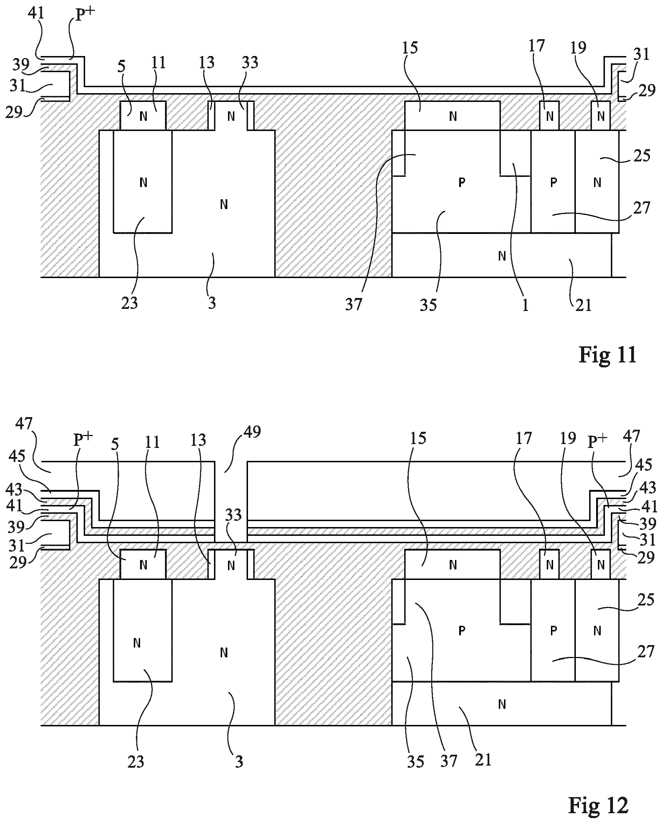

A l'étape de la figure 11, la couche isolante 29 est retirée par masquage de la face supérieure des zones de fabrication des transistors bipolaires de type NPN et PNP. Une couche isolante 39 et une couche de silicium polycristallin 41 fortement dopée de type P sont déposées sur la face supérieure de la structure. La couche 41 est déposée pour former la base extrinsèque du transistor bipolaire de type NPN. A titre d'exemple, la couche 39 est en oxyde ou en oxynitrure de silicium.

A l'étape de la figure 12, deux couches isolantes 43 et 45 et une couche de résine photosensible 47 sont déposées successivement sur la face supérieure de la couche 41. A titre d'exemple les couches isolantes sont en oxyde de silicium et en nitrure de silicium. Un masque de gravure est formé dans la couche de résine 47. Une ouverture 49, de largeur inférieure à celle du caisson 33, est formée dans les couches 41, 43 et 45 au-dessus du caisson 33.

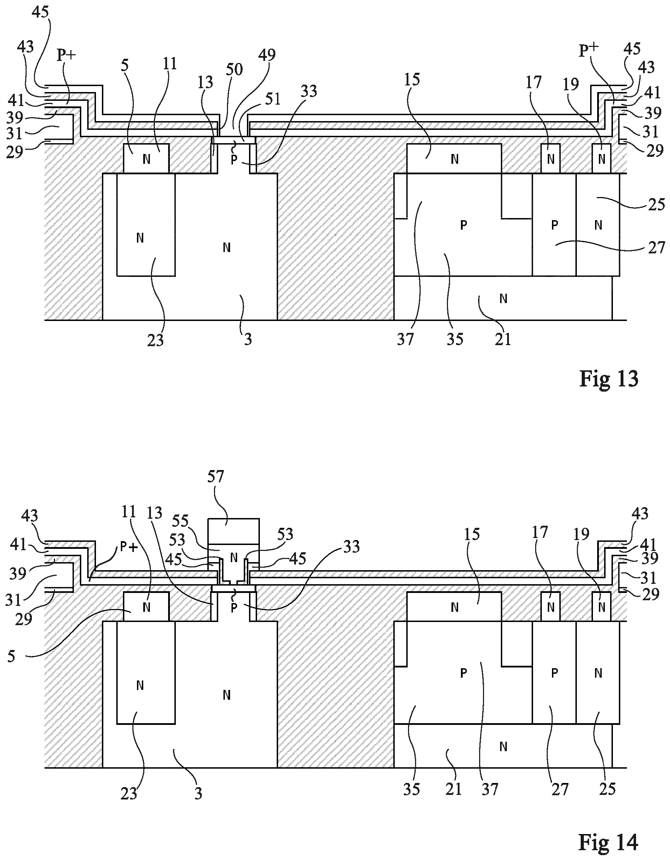

A l'étape de la figure 13, après retrait de la couche de résine photosensible 47, des espaceurs 50 sont formés par dépôt puis gravure d'une couche de nitrure de silicium pour protéger les parois de l'ouverture 49. Une portion de la couche 39 d'oxyde de silicium est retirée par voie humide dans le fond de l'ouverture 49. Une couche 51 semiconductrice, par exemple en silicium-germanium, est formée par croissance épitaxiale sélective par rapport aux matériaux diélectriques au-dessus du caisson 33. La couche 51 est formée sur le caisson 33 et la région 13 de la couche 5 et s'étend sur une largeur supérieure à celle de l'ouverture 49. Ainsi, la couche 51 est en contact par sa face inférieure avec le caisson 33 formant le collecteur du transistor NPN et est en contact par la périphérie de sa face supérieure avec la couche 41 dopée fortement de type P formant la base extrinsèque du transistor NPN. La couche 51 forme la base intrinsèque du transistor NPN.

A l'étape de la figure 14, on réalise, du côté gauche de la figure, l'émetteur du transistor bipolaire de type NPN. Pour cela, on forme au préalable deux espaceurs isolants 53 positionnés au fond et contre les parois de l'ouverture 49. Les espaceurs 53 délimitent sur la couche 51 une ouverture d'une dimension élémentaire comprise entre 50 et 100 nm. A titre d'exemple, les espaceurs 53 sont en oxyde de silicium. Une couche semiconductrice 55 fortement dopée de type N et une couche de résine photosensible 57 sont déposées successivement sur la face supérieure de la structure. Les couches 45, 55 et 57 sont ensuite retirées par gravure afin de ne laisser qu'une portion desdites couches sur la face supérieure de la structure. Les portions restantes des couches 45, 55 et 57 ont une largeur semblable à la largeur de la région 13 de la couche 5. La couche 55 forme le contact d'émetteur du transistor bipolaire de type NPN. La couche 55 est en contact avec la couche 51 qui forme la base intrinsèque du même transistor.

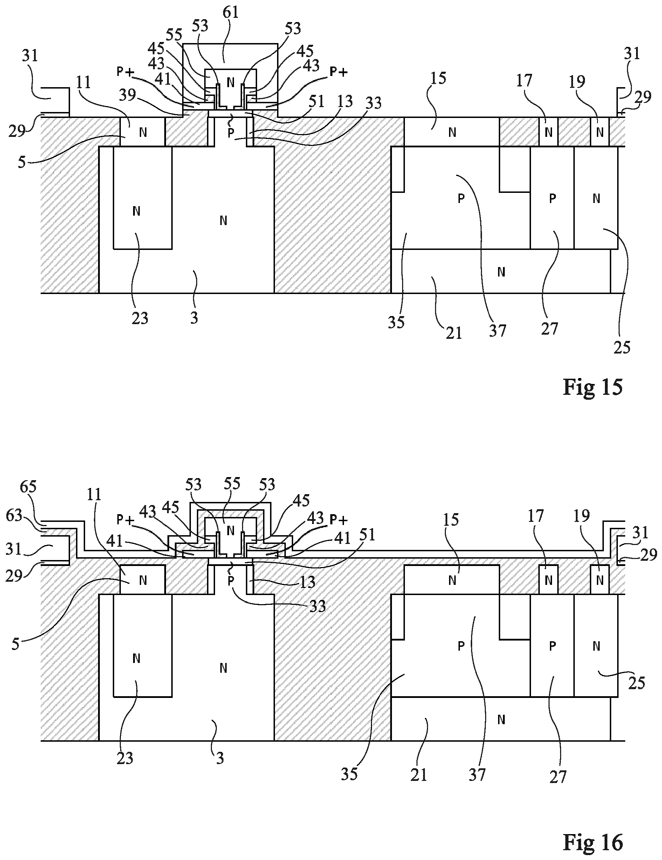

A l'étape de la figure 15, la couche 57 de résine photosensible est retirée et une autre couche 61 de résine photosensible est déposée sur la face supérieure de la structure. Un nouveau masque de gravure est formé dans la couche 61 de résine photosensible. Le masque de gravure permet de ne laisser qu'une portion des couches 39 et 41 sur la face supérieure de la structure. Les portions restantes des couches 39 et 41 sont positionnées sur la zone 13 de la couche 5 mais ont une largeur plus grande que la largeur de la zone 13. La couche 61 de résine photosensible est ensuite retirée.

A l'étape de la figure 16, une couche isolante 63 et une couche isolante 65, sélectivement gravable par rapport à la couche isolante 63, sont déposées sur la face supérieure de la structure. A titre d'exemple, la couche isolante 63 est une couche d'oxyde de silicium et la couche isolante 65 est une couche de nitrure de silicium.

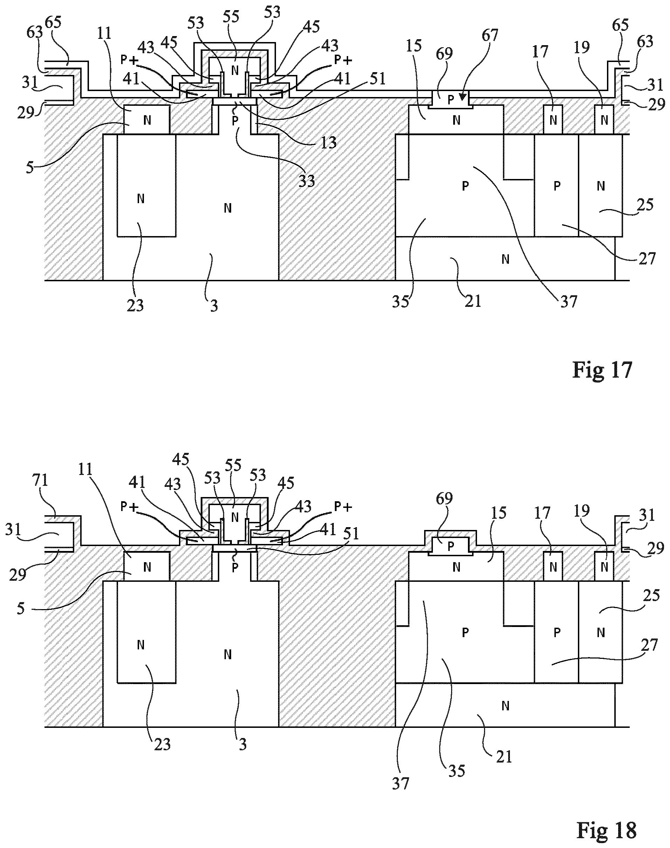

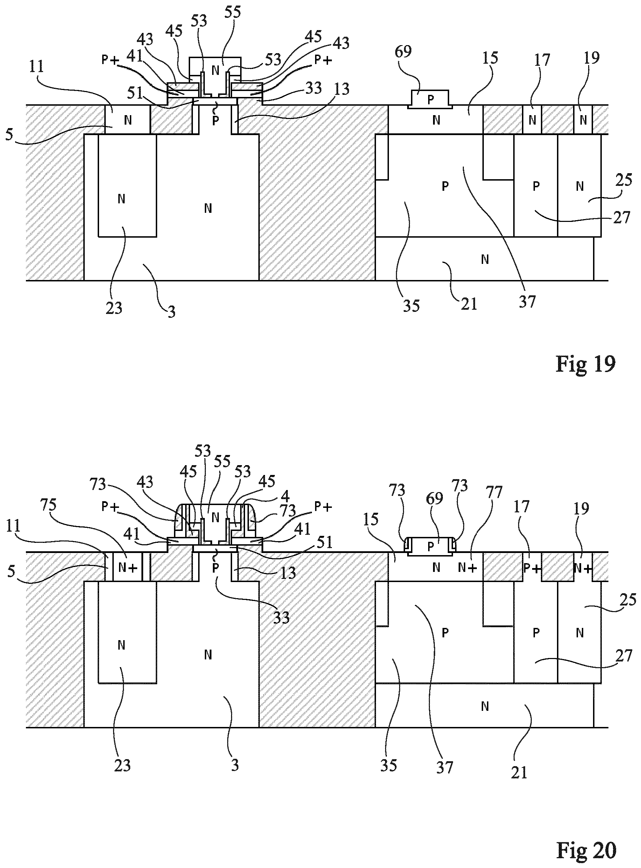

A l'étape de la figure 17, du côté droit de la figure, une ouverture 67 est réalisée par masquage dans les couches 63 et 65. L'ouverture 67 est réalisée au-dessus d'une portion de la région 15 de la couche 5 et s'étend sur toute l'épaisseur des couches isolantes 63 et 65. Une couche semiconductrice 69 fortement dopée de type P est formée par épitaxie sélective dans l'ouverture 67. La couche 69 est l'émetteur du transistor bipolaire de type PNP. La couche 69 peut être dopée avec des atomes de carbone afin de réduire la diffusion des atomes dopants dans le reste de la structure. Le dépôt de la couche 69 permet l'optimisation du profil de dopage de l'émetteur du transistor bipolaire de type PNP. De plus, la couche 69 est déposée dans l'ouverture 67 ce qui permet le contrôle de la morphologie de l'émetteur. En effet, les contacts finaux d'émetteur et de base du transistor bipolaire de type PNP seront proches et à l'étape de la figure 20, des espaceurs pourront être formés sur les côtés de la couche 69 qui isoleront les contacts d'émetteur et de base du transistor bipolaire de type PNP. Par ailleurs, le dépôt de la couche 69 a un faible budget thermique et n'influe pas thermiquement sur le dopage de la couche 51 formant la base du transistor bipolaire de type NPN.

A l'étape de la figure 18, les couches isolantes 63 et 65 sont retirées, par exemple par gravure humide. Une nouvelle couche isolante 71 est déposée sur la face supérieure de la structure. La couche 71 protège les transistors bipolaires de type NPN et PNP lors d'étapes de dopage des grilles de transistors MOS. Une fois ces étapes terminées, la couche 71 est retirée.

A l'étape de la figure 19, les couches 29 et 31 sont retirées de toute la structure et les étapes illustrées par les figures 19, 20 et 21 sont communes à la fabrication des transistors bipolaires et à la fabrication des transistors MOS.

A l'étape de la figure 20, on forme des espaceurs doubles 73 sur les faces latérales externes des émetteurs des transistors bipolaires. La largeur de la couche 41 est adaptée à recevoir en plus des espaceurs doubles 73 une zone siliciurée recevant le contact de base du transistor bipolaire de type NPN. Ces espaceurs sont par exemple composés d'une couche de nitrure et d'une couche d'oxyde de silicium. Des atomes dopants de type N sont implantés simultanément dans une partie centrale 75 de la région 11 de la couche 5, dans une portion 77 de la région 15 de la couche 5 et dans la région 19 de la couche 5. La portion 77 est positionnée sur une extrémité de la région 15. La partie centrale 75 de la région 11 améliore le contact de collecteur du transistor bipolaire de type NPN. La portion 77 de la région 15 améliore le contact de base du transistor bipolaire de type PNP. La région 19 améliore le contact isolant du transistor bipolaire de type PNP. Des atomes dopants de type P sont implantés dans la région 17 de la couche 5. La région 17 améliore le contact de collecteur du transistor bipolaire de type PNP.

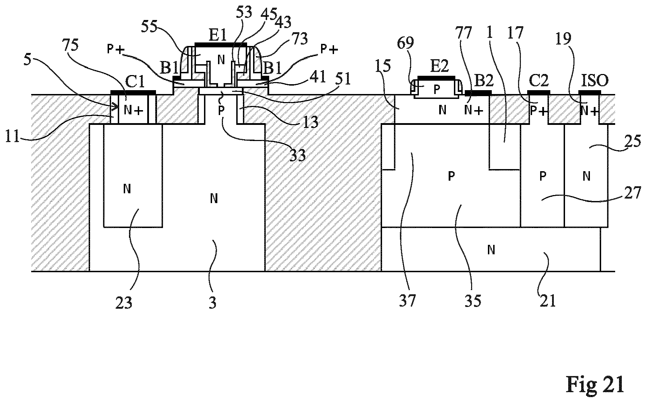

A l'étape de la figure 21, des siliciurations E1, B1, C1, E2, B2, C2 et ISO sont formées sur les zones de contact des transistors bipolaires. La siliciuration E1 est formée sur la face supérieure de la couche 55 et forme le contact à l'émetteur du transistor bipolaire de type NPN. La siliciuration B1 est formée sur la face supérieure visible de la couche 41 et forme le contact à la base du transistor bipolaire de type NPN. La siliciuration C1 est formée sur la face supérieure de la partie 75 et forme le contact au collecteur du transistor bipolaire de type NPN. La siliciuration E2 est formée sur la face supérieure de la couche 69 et forme le contact à l'émetteur du transistor bipolaire de type PNP. La siliciuration B2 est formée sur la face supérieure de la portion 77 de la couche 5 et forme le contact à la base du transistor bipolaire de type PNP. La siliciuration C2 est formée sur la face supérieure de la région 17 de la couche 5 et forme le contact au collecteur du transistor bipolaire de type PNP. La siliciuration ISO est formée sur la face supérieure de la région 19 de la couche 5 et forme un contact au caisson 21 du transistor bipolaire de type PNP. Des contacts électriques sont ensuite déposés sur les siliciurations.

A titre d'exemple, le procédé décrit précédemment peut être réalisé avec les niveaux de dopages donnés dans les tableaux suivants.

Pour le transistor bipolaire de type PNP :

| Eléments | Type de conductivité | Niveau de dopage (atomes. cm⁻³) |
|---|---|---|
| Caisson 21 | N | De 5×10¹⁶ à 5x10¹⁷, par exemple 10¹⁷ |
| Collecteur Extrinsèque (caisson 35) | P | De 10¹⁷ à 10¹⁸, par exemple 5x10¹⁷ |
| Collecteur Intrinsèque (caisson 37) | P | De 5x10¹⁷ à 5x10¹⁸, par exemple 2x10¹⁸ |
| Caisson 25 | N | De 7x10¹⁹ à 3x10²⁰, par exemple 10²⁰ |
| Caisson 27 | P | De 5x10¹⁷ à 5x10¹⁸, par exemple 10¹⁸ |
| Région 15 de la couche 5 | N | <10¹⁶ |
| Région 17 de la couche 5 | P | De 8x10²⁰ à 5x10²¹, par exemple 2x10²¹ |
| Région 19 de la couche 5 | N | De 8x10²⁰ à 5x10²¹, par exemple 2x10²¹ |
| Base (portion 77 de la région 15) | N | De 10¹⁷ à 10¹⁸, par exemple 5x10¹⁷ |
| Emetteur (couche 69) | P | De 5x10¹⁹ à 5x10²⁰, par exemple 10²⁰ |

Pour le transistor bipolaire de type NPN :

| Eléments | Type de conductivité | Niveau de dopage (atomes.cm⁻³) |
|---|---|---|
| Collecteur (Caisson 3) | N | De 10¹⁹ à 10²⁰, par exemple 5x10¹⁹ |
| Caisson 23 | N | De 7x10¹⁹ à 3x10²⁰, par exemple 10²⁰ |
| Caisson 33 | N | De 5x10¹⁸ à 10²⁰, par exemple 2x10¹⁹ |
| Partie Centrale 75 de la région 11 | N | De 8x10²⁰ à 5x10²¹, par exemple 2x10²¹ |
| Base Intrinsèque (Couche 51) | P | De 10¹⁹ à 10²⁰, par exemple 5x10¹⁹ |
| Base Extrinsèque (Couche 41) | P | De 5x10²⁰ à 5x10²¹, par exemple 10²¹ |
| Emetteur (couche 55) | N | De 7x10¹⁹ à 10²¹, par exemple 3x10²¹ |

A titre d'exemple, le transistor PNP fabriqué par le procédé de fabrication décrit ici présente, dans le cas des niveaux de dopage décrit ci-dessus, un gain compris entre 100 et 220 et une fréquence de transition comprise entre 30 et 45 GHz.

## Revendications

1. Procédé de fabrication d'un transistor bipolaire de type PNP en parallèle de la fabrication d'un transistor bipolaire de type NPN, et de transistors MOS à canal N et à canal P, ce procédé comprenant, au niveau de la fabrication du transistor bipolaire de type PNP, les étapes successives suivantes :
a) dépôt, sur un substrat (1) semiconducteur dopé de type P, d'une première couche (5) semiconductrice dopée de type N et la division de ladite première couche (5) par des zones isolantes (9') en des première (19), deuxième (17) et troisième (15) régions, la troisième région (15) formant la base du transistor ;
b) implantation profonde dans le substrat (1) d'un caisson d'isolation (21) dopé de type N ;
c) implantation d'un premier caisson (25) dopé de type N entre ladite première région (19) et le caisson d'isolation (21) ;
d) implantation d'un deuxième caisson (27) dopé de type P dans le substrat (1), entre ladite deuxième région (17) et le caisson d'isolation (21) formant une jonction PN verticale avec le premier caisson (25) ;
e) implantation d'un troisième caisson (35, 37) dopé de type P dans le substrat (1), entre ladite troisième région (15) et le caisson d'isolation (21) et en contact avec le caisson d'isolation (21), ce troisième caisson (35, 37) et le deuxième caisson (27) formant le collecteur du transistor ;
f) dépôt d'une première couche isolante (63) et d'une deuxième couche isolante (65) sélectivement gravable par rapport à la première couche isolante (63) sur la troisième région (15) et création d'une ouverture (67) sur une portion de la troisième région (15) ;
g) épitaxie sélective d'une deuxième couche (69) semiconductrice dopée de type P dans ladite ouverture, cette deuxième couche (69) formant l'émetteur du transistor, et retrait des première et deuxième couches isolantes (63, 65) ;
h) implantation d'atomes dopants de type N dans la première région (19) ; et
i) implantation d'atomes dopants de type P dans la deuxième région (17),
les étapes a), b), c), d), et i) étant communes à des étapes de fabrication de transistors MOS à canal N et à canal P.

2. Procédé selon la revendication 1, dans lequel, à l'étape e), l'implantation du troisième caisson (35, 37) est réalisée par une implantation profonde d'un quatrième caisson (35) dopé de type P et par une implantation d'un cinquième caisson (37) dopé de type P.

3. Procédé selon la revendication 1 ou 2, dans lequel la deuxième couche (69) est en outre dopée par des atomes de carbone.

4. Procédé selon l'une quelconque des revendications 1 à 3, comprenant en outre une étape j), postérieure à l'étape i), de formation de siliciurations (E1, B1, C1, E2, B2, C2, ISO) sur les faces supérieures des première, deuxième et troisième régions (15, 17, 19) et de la deuxième couche (69).

5. Procédé selon l'une quelconque des revendications 1 à 4, comprenant en outre une étape k) postérieure à l'étape i), de formation d'espaceurs (73) sur les bords latéraux de la deuxième couche (69).

6. Procédé selon l'une quelconque des revendications 1 à 5, dans lequel, à l'étape g), les première et deuxième couches (63, 65) isolantes sont retirées par gravure humide.

7. Procédé selon l'une quelconque des revendications 1 à 6, dans lequel, à l'étape a), la première couche (5) semiconductrice est déposée par épitaxie.

8. Procédé selon l'une quelconque des revendications 1 à 7, dans lequel la première couche isolante (63) est une couche d'oxyde de silicium et la deuxième couche isolante (65) est une couche de nitrure.

9. Procédé selon l'une quelconque des revendications 1 à 8, dans lequel le matériau isolant est de l'oxyde de silicium.

10. Procédé selon l'une quelconque des revendications 1 à 9, dans lequel le substrat (1) est en silicium.

## Patentansprüche

1. Verfahren zur Herstellung eines Bipolar-Transistors vom PNP-Typ parallel zur Herstellung eines Bipolar-Transistors vom NPN-Typ und von MOS-Transistoren mit N- und P-Kanal, wobei das Verfahren bei der Herstellung des Bipolar-Transistors vom PNP-Typ die folgenden aufeinanderfolgenden Schritte aufweist:
a) Abscheiden einer ersten N-Typ dotierten Halbleiterschicht (5) auf einem P-Typ dotierten Halbleitersubstrat (1) und Unterteilen der ersten Schicht (5) durch isolierende Zonen (9') in einen ersten (19), einen zweiten (17) und einen dritten (15) Bereich, wobei der dritte Bereich (15) die Basis des Transistors bildet;
b) tiefes Implantieren einer N-dotierten isolierenden Wanne (21) in das Substrat (1);
c) Implantieren einer ersten N-dotierten Wanne (25) zwischen dem ersten Bereich (19) und der isolierenden Wanne (21);
d) Implantieren einer zweiten P-dotierten Wanne (27) in das Substrat (1) zwischen dem zweiten Bereich (17) und der isolierenden Wanne (21), die einen vertikalen PN-Übergang mit der ersten Wanne (25) bildet;
e) Implantieren einer dritten P-dotierten Wanne (35, 37) in das Substrat (1) zwischen dem dritten Bereich (15) und der isolierenden Wanne (21) und in Kontakt mit der isolierenden Wanne (21), wobei die dritte Wanne (35, 37) und die zweite Wanne (27) den Kollektor des Transistors bilden;
f) Abscheiden einer ersten Isolierschicht (63) und einer zweiten, selektiv ätzbaren Isolierschicht (65) auf der erste Isolierschicht (63) auf dem dritten Bereich (15), und Erzeugen einer Öffnung (67) auf einem Teil des dritten Bereichs (15);
g) selektive Epitaxie einer zweiten P-dotierten Halbleiterschicht (69) in der Öffnung, wobei die zweite Schicht (69) den Emitter des Transistors bildet, und Entfernen der ersten und zweiten Isolierschicht (63, 65);
h) Implantieren von N-Typ Dotieratomen in den ersten Bereich (19); und
i) Implantieren von P-Typ Dotieratomen in den zweiten Bereich (17),
wobei die Schritte a), b), c), d), i) und j) den Herstellungsschritten für N-Kanal- und P-Kanal-MOS-Transistoren gemeinsam sind.

2. Verfahren nach Anspruch 1, wobei in Schritt e) das Implantieren der dritten Wanne (35, 37) durch eine tiefe Implantation einer vierten P-dotierten Wanne (35) und durch eine Implantation einer fünften P-dotierten Wanne (37) erfolgt.

3. Verfahren nach Anspruch 1 oder 2, wobei die zweite Schicht (69) zusätzlich mit Kohlenstoffatomen dotiert wird.

4. Verfahren nach einem der Ansprüche 1 bis 3, das ferner einen Schritt j) im Anschluss an Schritt i) aufweist, bei dem silizierte Bereiche (E1, B1, C1, E2, B2, C2, ISO) auf den oberen Oberflächen des ersten, zweiten und dritten Bereichs (15, 17, 19) und der zweiten Schicht (69) gebildet werden.

5. Verfahren nach einem der Ansprüche 1 bis 4, das ferner einen Schritt k) im Anschluss an Schritt i) zur Ausbildung von Abstandshaltern (73) an den seitlichen Kanten der zweiten Schicht (69) aufweist.

6. Verfahren nach einem der Ansprüche 1 bis 5, wobei in Schritt g) die erste und zweite Isolierschicht (63, 65) durch Nassätzen entfernt werden.

7. Verfahren nach einem der Ansprüche 1 bis 6, wobei in Schritt a) die erste Halbleiterschicht (5) durch Epitaxie abgeschieden wird.

8. Verfahren nach einem der Ansprüche 1 bis 7, wobei die erste Isolierschicht (63) eine Siliziumoxidschicht ist und die zweite Isolierschicht (65) eine Nitridschicht ist.

9. Verfahren nach einem der Ansprüche 1 bis 8, wobei das Isoliermaterial Siliziumoxid ist.

10. Verfahren nach einem der Ansprüche 1 bis 9, wobei das Substrat (1) aus Silizium hergestellt ist.

## Claims

1. A method of manufacturing a PNP-type bipolar transistor in parallel with the manufacturing of an NPN-type bipolar transistor and of N- and P-channel MOS transistors, the method comprising, in the manufacturing of the PNP-type bipolar transistor, the successive steps of:
a) deposition, on a P-type doped semiconductor substrate (1), of a first N-type doped semiconductor layer (5) and division of said first layer (5) by insulating areas (9') into first (19), second (17), and third (15) regions, the third region (15) forming the base of the transistor ;
b) deep implantation into the substrate (1) of an N-type doped insulating well (21);
c) implantation of a first N-type doped well (25) between said first region (19) and the insulating well (21);
d) implantation of a second P-type doped well (27) into the substrate (1) between said second region (17) and the insulating well (21) forming a vertical PN junction with the first well (25) ;
e) implantation of a third P-type doped well (35, 37) into the substrate (1), between said third region (15) and the insulating well (21) and in contact with the insulating well (21), the third well (35, 37) and the second well (27) forming the collector of the transistor;
f) deposition of a first insulating layer (63) and of a second insulating layer (65) selectively etchable over the first insulating layer (63) on the third region (15) and creation of an opening (67) on a portion of the third region (15);
g) selective epitaxy of a second P-type doped semiconductor layer (69) in said opening, the second layer (69) forming the emitter of the transistor, and removal of the first and second insulating layers (63, 65);
h) implantation of N-type dopant atoms into the first region (19); and
i) implantation of P-type dopant atoms into the second region (17),
steps a), b), c), d), i), j) being common to N-channel and P-channel MOS transistor manufacturing steps.

2. The method of claim 1, wherein, at step e), the implantation of the third well (35, 37) is performed by deep implantation of a fourth P-type doped well (35) and by an implantation of a fifth P-type doped well (37).

3. The method of claim 1 or 2, wherein the second layer (69) is further doped with carbon atoms.

4. The method of any of claims 1 to 3, further comprising a step j), subsequent to step i), of forming siliconized areas (E1, B1, C1, E2, B2, C2, ISO) on the upper surfaces of the first, second, and third regions (15, 17, 19) and of the second layer (69).

5. The method of any of claims 1 to 4, further comprising a step k) subsequent to step i) of forming spacers (73) on the lateral edges of the second layer (69).

6. The method of any of claims 1 to 5, wherein, at step g), the first and second insulating layers (63, 65) are removed by wet etching.

7. The method of any of claims 1 to 6, wherein, at step a), the first semiconductor layer (5) is deposited by epitaxy.

8. The method of any of claims 1 to 7, wherein the first insulating layer (63) is a silicon oxide layer and the second insulating layer (65) is a nitride layer.

9. The method of any of claims 1 to 8, wherein the insulating material is silicon oxide.

10. The method of any of claims 1 to 9, wherein the substrate (1) is made of silicon.
